# EUROPÄISCHE PATENTSCHRIFT

(11) **EP 1 031 040 B1**
(45) Veröffentlichungstag und Bekanntmachung des Hinweises auf die Patenterteilung: **24.11.2004**
(21) Anmeldenummer: 99947317.6
(22) Anmeldetag: 10.09.1999
(51) Int. Cl.: G01R 29/24

(54) **VORRICHTUNG UND VERFAHREN ZUM UMWANDELN VON LADUNGSFLUSS IN EIN FREQUENZSIGNAL**
DEVICE AND METHOD FOR CONVERTING A CHARGE-FLOW INTO A FREQUENCY SIGNAL
DISPOSITIF ET PROCEDE POUR CONVERTIR UN FLUX DE CHARGE EN UN SIGNAL DE FREQUENCE

(30) Priorität: 10.09.1998 DE 19841308
(43) Veröffentlichungstag der Anmeldung: 30.08.2000
(73) Patentinhaber: Gesellschaft für Schwerionenforschung mbH, 64291 Darmstadt (DE)
(72) Erfinder: BADURA, Eugen, D-64291 Darmstadt (DE)
(74) Vertreter: Boeters, Hans Dietrich, Dr.
(86) Internationale Anmeldenummer: PCT/EP1999/006716
(87) Internationale Veröffentlichungsnummer: WO 2000/016110

(56) Entgegenhaltungen:
- WO-A-97/40392

## Beschreibung

Die vorliegende Erfindung betrifft eine Vorrichtung und ein Verfahren zum Umwandeln von Ladungsfluß in ein Frequenzsignal.

Eine derartige Vorrichtung, auch unter der Bezeichnung Ladungs-Frequenz-Wandler bekannt, ist eine elektronische Schaltung, die zur Messung von elektrischem Ladungsfluß dient.

Bei einer bekannten schaltungstechnischen Anordnung eines Ladungs-Frequenz-Wandlers sind ein Integrator und ein Komparator in Reihe geschaltet. Der Anordnung wird eingangsseitig elektrische Ladung über einen Eingang der Schaltung zugeführt und durch den Integrator aufintegriert. Der Integrator liefert an den Verstärker ein Spannungssignal, das dem Integral der zugeführten Ladung entspricht. Das integrierte Spannungssignal wird im Komparator mit einem voreingestellten Ladungs-Vergleichswert verglichen. Hat das Signal größenmäßig den Vergleichswert erreicht, gibt der Komparator einen Impuls an den Ausgang der Anordnung ab. Anschließend wird der Integrator zurückgesetzt, und die Abfolge des Integrierens und Vergleichens beginnt von neuem. Am Ausgang der Anordnung entsteht also eine Impulsfolge über der Zeit, deren momentane Frequenz ein Maß für die zugeführte elektrische Ladungsmenge pro Zeiteinheit - also Ladungsfluß - ist.

Nachteilig an dieser Anordnung ist, daß der Integrator während des Rücksetzvorganges nicht arbeiten kann, also eine Totzeit entsteht, während der kein Ladungsfluß gemessen werden kann. Bei zeitkritischen Anwendungen, also solchen, bei denen sich die zugeführte Ladungsmenge rasch ändert und sehr schnell erfaßt werden muß, geht durch das Rücksetzen des Integrators in der Schaltung zu viel Zeit verloren. Dies kann zu Meßungenauigkeiten führen, die insbesondere bei sicherheitsrelevanten Anwendungen wie z.B. in der Ionenstrahltherapie nicht toleriert werden können.

Ziel der Erfindung ist es daher, eine Vorrichtung und ein Verfahren zum Umwandeln von Ladungsfluß in ein Frequenzsignal zu schaffen, welche eine exakte, schnelle und zuverlässige Messung der Ladung gewährleisten. Dieses Ziel wird durch eine Vorrichtung mit den Merkmalen gemäß. den Ansprüchen 1 und 14 bzw. ein Verfahren mit den Merkmalen gemäß den Ansprüchen 8 und 21 erreicht. Vorteilhafte Weiterbildungen sind in den Unteransprüchen definiert.

Die erfindungsgemäße Vorrichtung und das erfindungsgemäße Verfahren sind mit einer Reihe von Vorteilen verbunden.

Durch das Vorsehen zweier paralleler Schaltungszweige kann die Ladungsflußmessung in jeweils dem anderen Schaltungszweig fortgesetzt werden, wenn der Ladungsfluß in dem einen Schaltungszweig den voreingestellten Schwellenwert erreicht hat und der zugehörige Integrator zurückgesetzt werden muß. Damit entfällt die Totzeit bei der Messung für die Rücksetzung des Integrators.

Durch das Vorsehen verschiedener Schwellenwerte für jeweils einen Komparator entsteht eine Schaltung mit erweiterbarem Meßbereich. Zusätzlich werden die Schaltungszweige seltener geschaltet, so daß die auch die mit diesen Schaltvorgängen einhergehenden Schaltzeiten und Totzeiten minimiert werden.

Durch das Zuschalten des anderen Schaltungszweiges noch während der Messung in dem einen Schaltungszweig kann auch noch die verbleibende Schaltzeit beim Übergang vom einen auf den anderen Schaltungszweig eliminiert werden. Damit werden eine Vorrichtung und ein Verfahren geschaffen, mit denen andauernd, also ohne Totzeiten Ladungsfluß gemessen werden kann.

Zudem ist die Schaltung aus kommerziell verfügbaren Komponenten aufgebaut, kann also kostengünstig realisiert werden. Auch lassen sich die Entwurfseigenschaften der Schaltung in einer Großserienproduktion zuverlässig reproduzieren.

Die Erfindung wird anhand der Zeichnung näher beschrieben. In der Zeichnung zeigt
- Fig. 1: ein Blockschaltbild eines Ladungs-Frequenz-Wandlers gemäß einem ersten Ausführungsbeispiel der Erfindung,
- Fig. 2A, B: ein Blockschaltbild eines Ladungs-Frequenz-Wandlers gemäß einem zweiten Ausführungsbeispiel der Erfindung,
- Fig. 3: ein Schaltbild für den analogen Teil des Ladungs-Frequenz-Wandlers gemäß dem zweiten Ausführungsbeispiel der Erfindung,
- Fig. 4: ein Schaltbild für den digitalen Teil sowie die Schwellenspannungsgeneratoren des Ladungs-Frequenz-Wandlers gemäß dem zweiten Ausführungsbeispiel der Erfindung,
- Fig. 5: ein Kennliniendiagramm für den Ladungs-Frequenz-Wandler gemäß dem zweiten Ausführungsbeispiel der Erfindung und
- Fig. 6: ein Blockschaltbild einer Anwendung des erfindungsgemäßen Ladungs-Frequenz-Wandlers.

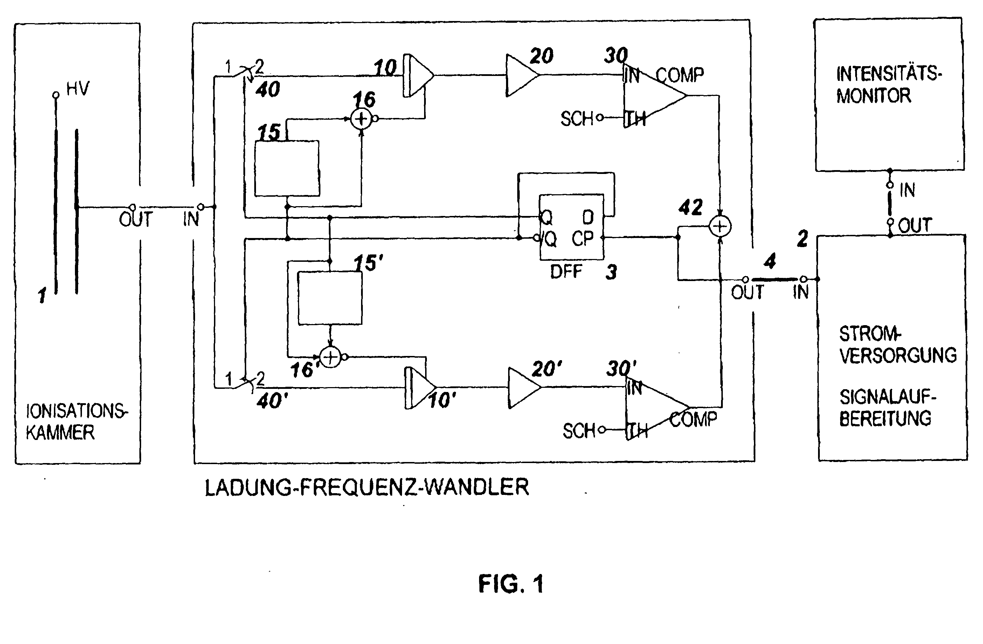

Fig. 1 zeigt den Aufbau eines Ladungs-Frequenz-Wandlers als Blockschaltbild gemäß dem ersten Ausführungsbeispiel der Erfindung. Der Ladungs-Frequenz-Wandler besteht im wesentlichen aus zwei parallelen Schaltungszweigen (auch Einzelpulsgruppen genannt) Z, Z', die jeweils identisch aufgebaut sind. Die Schaltungszweige Z, Z' werden durch je ein Schaltelement 40, 40' im Gegentakt zueinander an den Eingang 1 durch- bzw. abgeschaltet. Jeder der Zweige weist einen Integrator 10, 10' auf, der zum Aufsummieren des über das gerade durchgeschaltete Schaltelement 40 oder 40' angelieferten Ladungsflusses und zum Abgeben eines dem Integral entsprechenden Spannungssignals dient. Der Ausgang des Integrators ist mit einem Verstärker 20, 20' verbunden. Dieses Spannungssignal wird einem Komparator 30, 30' zugeführt. Am zweiten Eingang des Komparators 30, 30' liegt ein Schwellenspannungssignal als Vergleichssignal an. Das Schwellenspannungssignal - eine Gleichspannung - wird durch einen Spannungsteiler größenmäßig eingestellt.

Die beiden Komparatoren 30, 30' sind ausgangsseitig über einen Addierer 4 mit einem D-Flip-Flop 3 gekoppelt, über welches jeweils über ein Verzögerungsglied 15, 15' der Integrator 10 oder 10' zurückgesetzt und die Schaltelemente 40, 40' angesteuert werden. Jeder der beiden komplementären Ausgänge Q, Q des D-Flip-Flops 3 ist mit einem der beiden Schaltelemente 40, 40' verbunden. Hierdurch werden die beiden Schaltelemente im Gegentakt zueinander geschaltet. Hinter dem Addierer 4 befindet sich ein Abgriff 42 für das Ausgangssignal.

Die beiden Zweige Z, Z' sind also abwechselnd aktiv, d.h., während im durchgeschalteten Zweig das Ladungsflußsignal integriert, verstärkt und mit der Schwellenspannung verglichen wird, ruht der gesperrte Zweig; es verbleibt genügend Zeit, den dortigen Integrator auf null zurückzusetzen.

Der Integrator 10, 10' des durchgeschalteten Zweiges integriert das vom Eingang der Schaltung zugeführte Ladungsflußsignal und setzt das integrierte Ladungsflußsignal in ein Spannungssignal um. Das Spannungssignal wird im Verstärker 20, 20' verstärkt und wird dann einem der Eingänge des Komparators 30, 30' zugeführt. Der Komparator 30, 30' vergleicht dieses Signal größenmäßig mit der seinem anderen Eingang anliegenden Schwellenspannung. Wenn das integrierte Ladungsflußsignal die Schwellenspannung erreicht, gibt der Komparator an seinem Ausgang einen Impuls ab. Dieser Impuls gelangt über den Addierer 4 zum D-Flip-Flop 3. Das D-Flip-Flop 3 ändert seinen Zustand, d.h. die Signale an seinen Ausgängen Q bzw. Q werden jeweils invertiert. Hierdurch wird das bisher geöffnete Schaltelement durchgeschaltet, das bisher durchgeschaltete Schaltelement geöffnet und der zugehörige Integrator zurückgesetzt. Die Rücksetzung erfolgt hierbei sofort; das Aufheben der Rücksetzung erfolgt jedoch erst kurze Zeit (typischer Wert: 50 ns) nach der Durchschaltung des betreffenden Zweiges. Hierzu sind Verzögerungselemente 15, 15' vorgesehen, die verhindern, daß ein beim Durchschalten des betreffenden Zweiges auftretender Stromstoß durch den Integrator 10, 10' aufintegriert wird und die Messung verfälscht.

Nun setzt sich der oben beschriebene Ablauf im anderen Zweig fort, während der bisher aktive Zweig ruht.

Die beiden Zweige liefern also abwechselnd Impulse an den Addierer 4, so daß am Abgriff 42 eine Impulsfolge über der Zeit entsteht, deren Frequenz den eingangsseitigen Ladungsfluß pro Zeit repräsentiert.

Die Auflösung dieser Schaltung liegt bei 10pC/Impuls, der Ladungsfluß liegt bei 25 µC/s. Mit dieser Schaltung können bereits Ausgangssignale mit Frequenzen bis zu 1 MHz für Strahlintensitäten von 10⁶ bis 10⁸ Teilchen pro Sekunde erzeugt werden. Die Fehlerrate bleibt hierbei unter 3%.

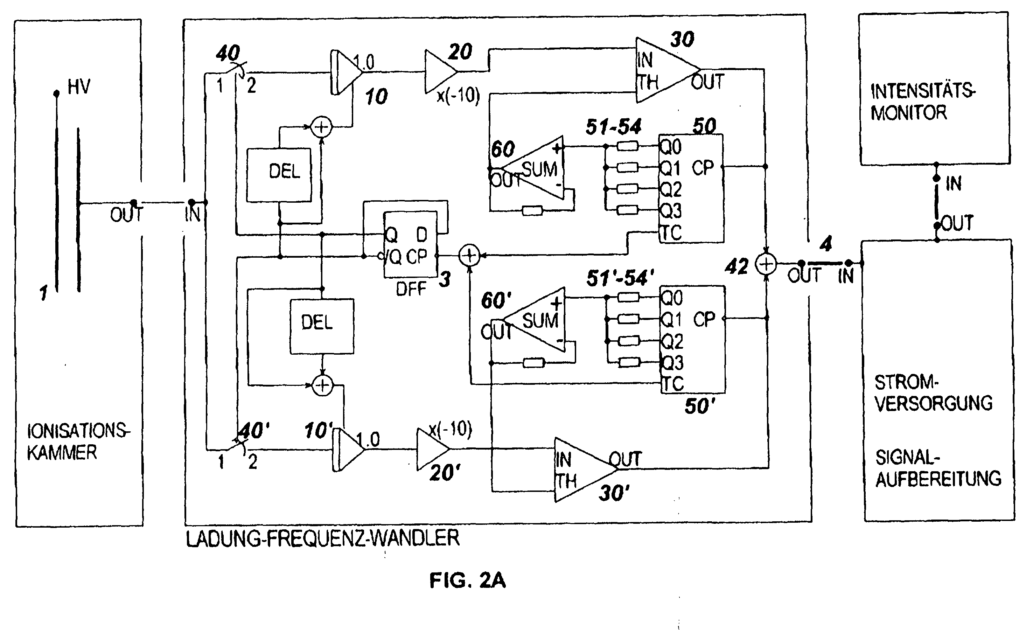

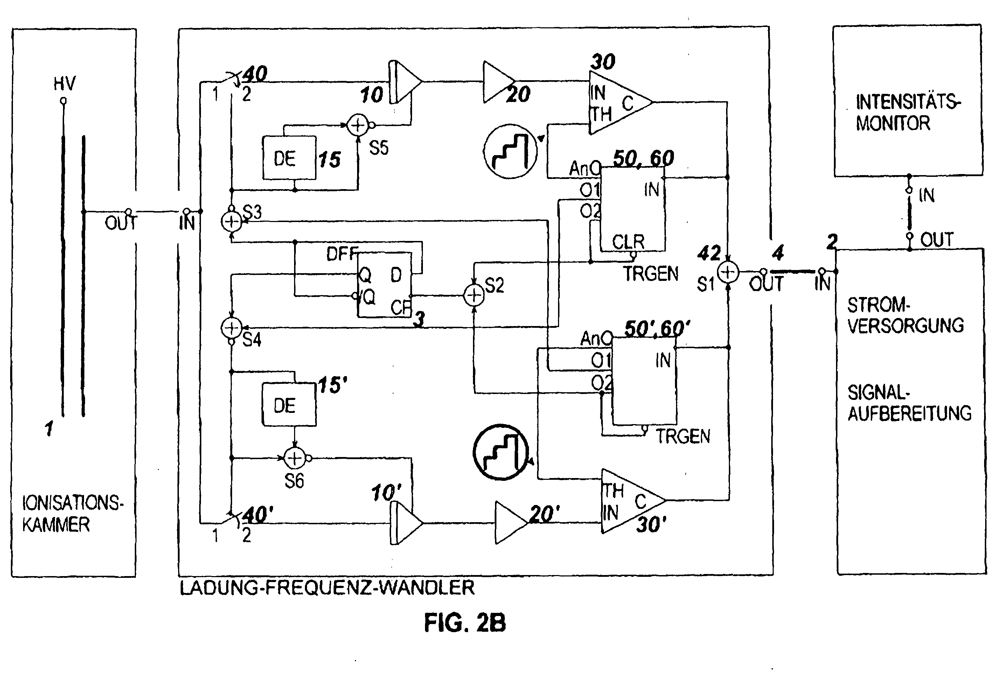

Die Fehlerrate kann noch weiter gesenkt werden, wenn die Umschaltung zwischen den beiden Zweigen seltener erfolgt. Dies wird mit einer Schaltung gemäß Fig. 2A, B erreicht. Fig. 2A zeigt den Aufbau eines Ladungs-Frequenz-Wandlers als Blockschaltbild gemäß dem zweiten Ausführungsbeispiel der Erfindung. Diese Schaltung ist gegenüber der Schaltung der Fig. 1 um jeweils eine Komponente 50, 60 bzw. 50', 60' zur Erzeugung verschiedener Schwellenspannungswerte erweitert. Die Schwellenspannungswerte werden erzeugt, indem verschiedene Widerstände 51-54 bzw. 51'-54' an den Eingang von Operationsverstärkern 60, 60' aufgeschaltet werden. Die Aufschaltung eines der Schwellenspannungswerte erfolgt durch Binärzählerbausteine 50, 50', die jeweils durch die Impulse des Ausgangssignale der Komparatoren 30, 30' ausgelöst werden. Mit den vier Widerständen 51-54 bzw. 51'-54' können also jeweils 16 verschiedene Schwellenspannungswerte (oder Treppenspannungen) erzeugt werden. Bei einem Widerstandsverhältnis zweier benachbarter Widerstände von 2:1 kann somit der Meßbereich um das 15fache erweitert werden. Auch bei diesem Ausführungsbeispiel sind die beiden Zweige Z, Z' schaltungstechnisch identisch dimensioniert.

Wie beim ersten Ausführungsbeispiel wird das zu messende Ladungsflußsignal durch Takten der beiden Schaltelemente 40, 40' einem der beiden Zweige zugeführt. Abweichend von dem ersten Ausführungsbeispiel werden die beiden Zweige hier jedoch nicht exakt im Gegentakt zueinander durchgeschaltet, sondern zeitlich geringfügig überlappend, d.h., die Schließzeiten der beiden Schaltelemente überlappen sich zu Beginn und Ende eines jeden Taktes.

Es sei nun angenommen, der Zweig Z sei der aktive Zweig. Zu Taktbeginn des aktiven Zweiges ist der Integrator 10 auf null gesetzt, und am Komparator 30 liegt der niedrigste Schwellenspannungswert an. Wenn das vom Verstärker 20 gelieferte integrierte Ladungsflußsignal größenmäßig den ersten Schwellenspannungswert erreicht hat, dann wird - wie beim ersten Ausführungsbeispiel - ein Impuls an den Ausgang abgegeben. Abweichend von dem Ladungs-Frequenz-Wandler des ersten Ausführungsbeispiels wird jedoch der Integrator nicht zurückgesetzt und auch keines der Schaltelemente geschaltet, d.h. der Zweig Z ist weiterhin aktiv. Es wird nun der Binärzähler 50 angesteuert, der sodann durch Durchschalten einer anderen Kombination aus den Widerständen 51-54 den nächsthöheren Schwellenspannungswert erzeugt und an den Eingang des Komparators 30 legt. Der Integrationsvorgang wird fortgesetzt, bis das integrierte Ladungsflußsignal größenmäßig den aktuellen Schwellenspannungswert erreicht. Dann wird wiederum ein Impuls abgegeben, und der Zyklus beginnt von neuem. Dieser Zyklus wiederholt sich, bis der letzte der 16 Schwellenspannungswerte erreicht ist; erst dann wird der aktive Zweig Z abgeschaltet und der Integrator 10 zurückgesetzt.

Der andere Zweig Z' wird jedoch nicht erst bei Erreichen des letzten Schwellenspannungswertes des anderen Zweiges Z durchgeschaltet, sondern schon beim Erreichen des vorletzten Schwellenspannungswertes. Somit sind während der letzten Meßphase beide Zweige Z, Z' aktiv. Damit kann auch der Meßfehler, der durch die Verzögerung beim Durchschalten eines Schaltelementes zu Beginn eines Zweigtaktes entsteht, eliminiert werden.

Der oben beschriebene Zyklus wiederholt sich nun für den Zweig Z' in gleicher Weise.

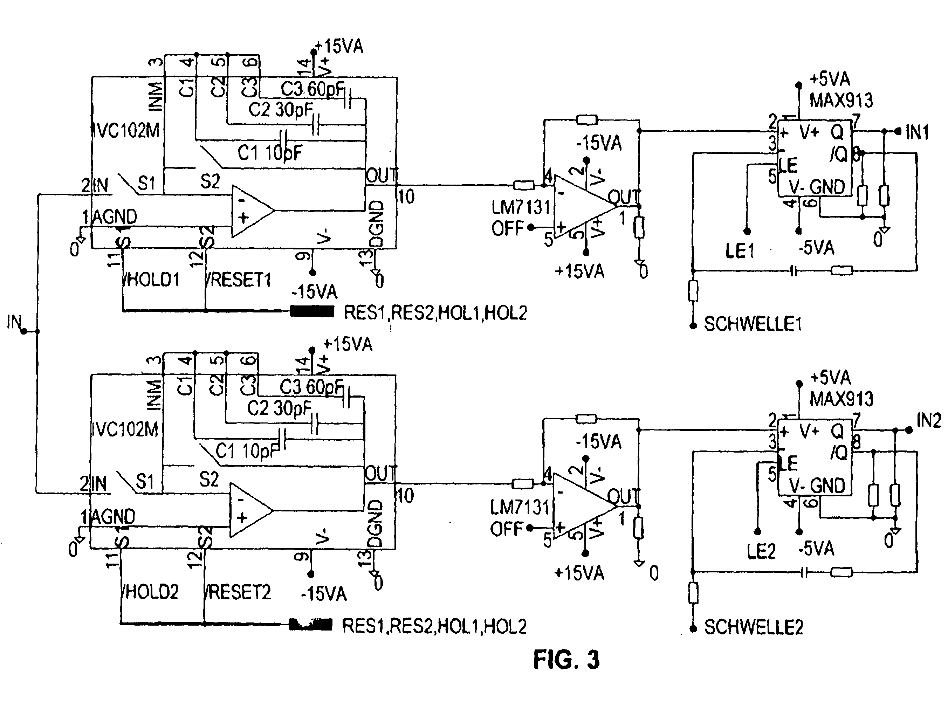

Fig. 3 zeigt ein Schaltbild für den analogen Teil des Ladungs-Frequenz-Wandlers, der beiden Ausführungsbeispielen der Erfindung gemeinsam ist. Der Integrator 10, 10' ist jeweils durch einen Operationsverstärker (OPAMP) mit kapazitiver Rückkopplungsbeschaltung 15, 15' realisiert, der zugeführte Ladungsfluß wird über Schaltelemente 40, 40' auf den invertierenden Eingang geschaltet. Die Verstärker 20, 20' sowie die Komparatoren 30, 30' sind durch weitere OPAMPs mit entsprechender Beschaltung realisiert.

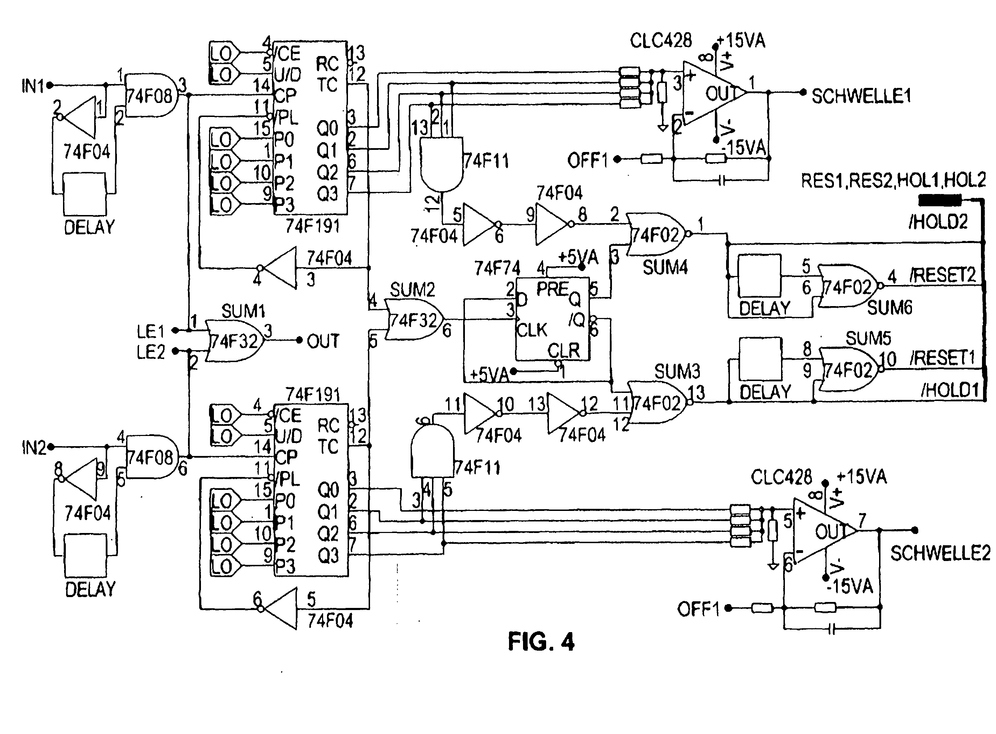

Fig. 4 zeigt ein Schaltbild für den digitalen Teil des Ladungs-Frequenz-Wandlers sowie die Schwellenspannungsgeneratoren gemäß dem zweiten Ausführungsbeispiel der Erfindung.

Der Schwellenspannungsgenerator kann prinzipiell auf verschiedene Weise aufgebaut sein. Wichtig ist hierbei, daß er mit jedem Impuls (bis hinunter auf ca. 10 ns) innerhalb von weniger als 100ns zuverlässig eine neuen Spannungsimpuls am Ausgang erzeugt. Selbstverständlich kann auch eine andere Anstufung der Schwellenspannungen realisiert werden. Dann enthält der Schwellenspannungsgenerator entsprechend mehr oder weniger Widerstände und einen Zähler mit entsprechend angepaßter Stellenzahl.

Anstelle eines Binärzählers kann auch eine andere Schaltung eingesetzt werden, mit der Treppenspannungen nacheinander ausgewählt werden können.

Anstelle der Erzeugung der verschiedenen Spannungswerte durch Aufschalten verschiedener Widerstandswerte auf den Operationsverstärker 60, 60' kann der Schwellenspannungsgenerator 50, 50'; 60, 60' auch mittels eines Digital/analog-Konverters realisiert sein, der eine Binärzahl in einen Spannungswert umsetzt. Fig. 2B zeigt das dahingehend abgewandelte Ausführungsbeispiel der Fig. 2A.

Mit einer Schaltung gemäß dem zweiten Ausführungsbeispiel unter Verwendung der in Fig. 3 und Fig. 4 angegebenen Bauelementen können Ladungsflüsse von 10⁻¹⁴ bis 10⁻⁴ C/s gemessen werden.

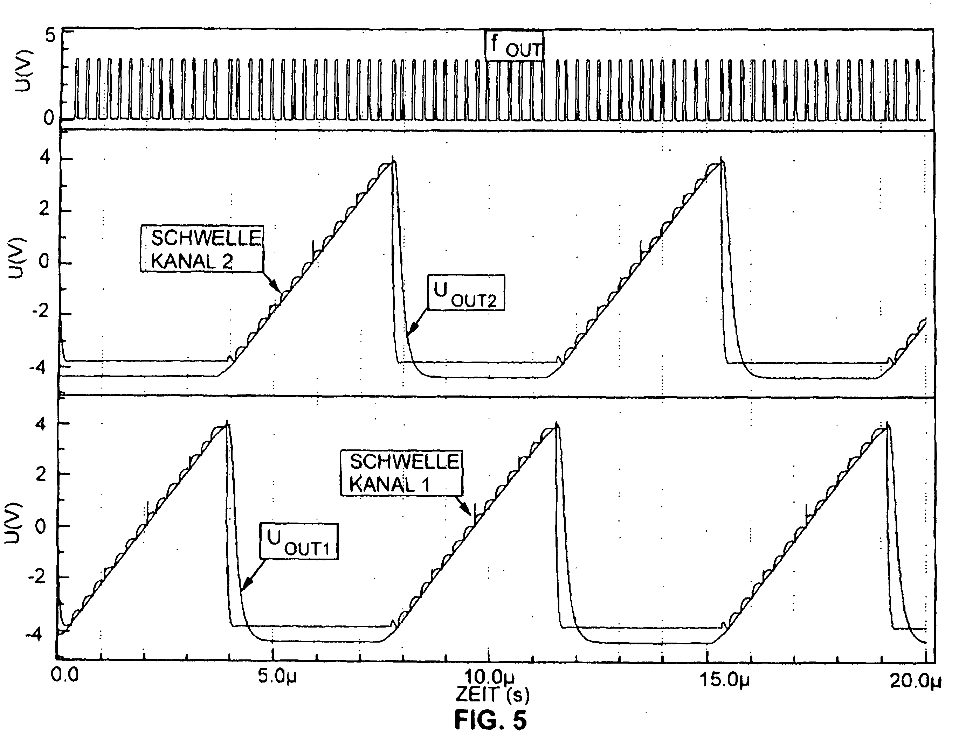

Fig. 5 zeigt ein Kennliniendiagramm für den Ladungs-Frequenz-Wandler gemäß dem zweiten Ausführungsbeispiel. Über die horizontale Zeitachse aufgetragen sind im unteren Diagramm die Spannungsverläufe an den beiden Eingängen des Komparators 30 im Zweig Z, im mittleren Diagramm die Spannungsverläufe an den beiden Eingängen des Komparators 30' im Zweig Z' und darüber das an den Ausgang 4 gelieferte Ausgangssignal. Die Schwellenspannungswerte liegen treppenförmig äquidistant zwischen -4 V und 4 V. Das den Komparatoren zugeführte integrierte Spannungssignal Uout1 bzw. Uout2 repräsentiert hier einen über die Zeit konstanten Ladungsfluß am Eingang 1. Jedem Berührungspunkt von Uout1 bzw. Uout2 mit einem Schwellenspannungswert entspricht ein Spannungsimpuls im Ausgangssignal. Aus der überlappenden Taktung der beiden Schalter 40, 40' folgt, daß sich die im Überlappungszeitraum angelieferte Ladung auf beide Zweige Z1, Z2 verteilt. Daraus resultiert die zeitliche Überlappung des Endes einer jeden Anstiegsflanke Uout1 bzw. Uout2 mit dem Beginn der jeweils folgenden Anstiegsflanke Uout2 bzw. Uout1 im anderen Zweig. Der nächste Schwellenspannungswert wird daher etwas später erreicht, weshalb dann eine etwas größere Lücke im Ausgangssignal erscheint.

Ist die völlige Eliminierung der Totzeiten durch das Schalten der Schaltelemente 40, 40' nicht erforderlich, so kann das Prinzip der Meßbereichserweiterung mittels der Schaltungskomponenten 50, 60 bzw. 50', 60' gemäß dem zweiten Ausführungsbeispiel direkt mit dem Ladungs-Frequenz-Wandler gemäß dem ersten Ausführungsbeispiel kombiniert werden.

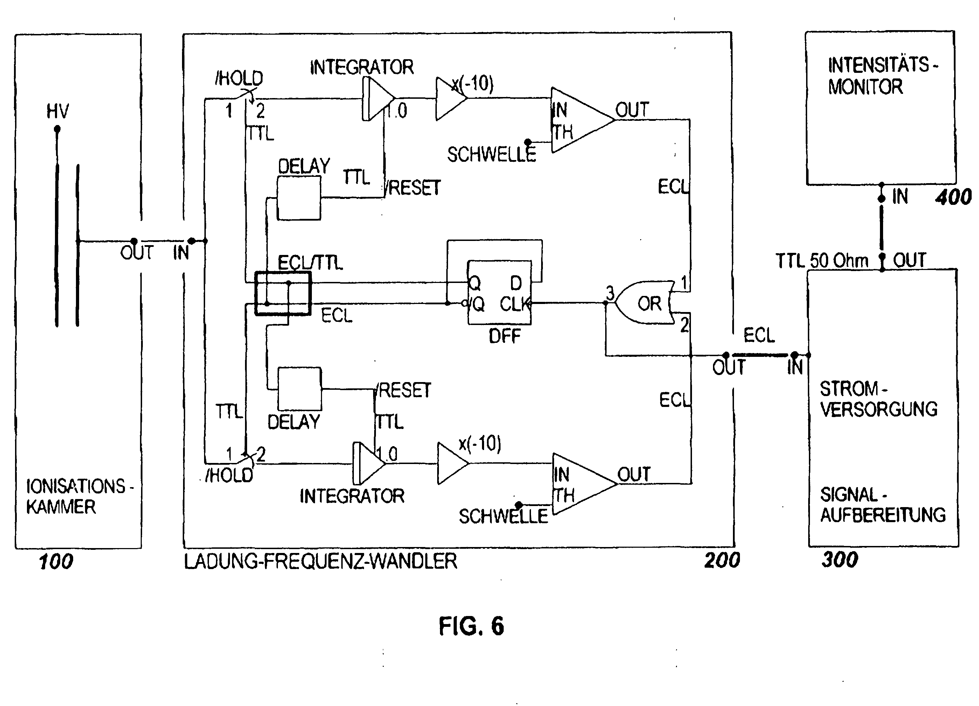

Der erfindungsgemäße Ladungs-Frequenz-Wandler und das erfindungsgemäße Verfahren sind vielseitig verwendbar. Fig. 6 zeigt ein Blockschaltbild einer Anwendung des erfindungsgemäßen Ladungs-Frequenz-Wandlers zur Intensitätsmessung von Schwerionenstrahlen in der Strahlentherapie. Als Detektor für die Ionenstrahlen dient eine Ionisationskammer 100, die in den Ionenstrahl gestellt ist. Die dort hindurchtretenden Ionenstrahlen erzeugen Ladung. Die Größe der erzeugten Ladung ist proportional zu den durch die Ionisationskammmer hindurchtretenden Ionen. Die Ladung wird dem Ladungs-Frequenz-Wandler 200 zugeführt. Das Ausgangssignal des Ladungs-Frequenz-Wandlers wird über eine Einheit zur Signalaufbereitung 300 einem Intensitätsmonitor 400 zugeführt, wo eine Auswertung des gemessenen Signals zur Bestrahlungsüberwachung bzw. Abschaltung des Strahles erfolgt. Gerade bei dieser Anwendung ist die durch die erfindungsgemäße Vorrichtung gewährleistete schnelle, zuverlässige und genaue Intensitätsmessung von größter Bedeutung.

## Patentansprüche

1. Vorrichtung zum Umwandeln von Ladungsfluß in ein Frequenzsignal, aufweisend:
zwei parallele Schaltungszweige (Z; Z'),
die abwechselnd mit Ladungsfluß beaufschlagbar sind und deren jeder eine Hintereinanderschaltung eines Schaltelements (40; 40'), eines Integrators (10; 10') und eines Komparators (30; 30') aufweist, wobei
die Schaltelemente (40; 40') zum Beaufschlagen eines der beiden Schaltungszweige (Z; Z') mit dem Ladungsfluß dienen und im beaufschlagten Schaltungszweig (Z; Z') der Integrator (10; 10') zum Integrieren des Ladungsflusses dient und rücksetzbar ausgelegt ist und der Komparator (30; 30') zum Abgeben eines Signals bei Übereinstimmen des integrierten Ladungsflusses mit einem bestimmten Schwellenwertsignal ausgelegt ist.

2. Vorrichtung gemäß Anspruch 1, **dadurch gekennzeichnet, daß** sie Steuermittel (3, 15, 16; 3', 15', 16') aufweist zum Zurücksetzen der Integratoren (10; 10') und zum Ansteuern der Schaltelemente (40; 40') bei Übereinstimmen des integrierten Ladungsflusses mit dem bestimmten Schwellenwertsignal.

3. Vorrichtung gemäß Anspruch 1 oder 2, **dadurch gekennzeichnet, daß** zwischen den Schaltelementen (40, 40') und den Integratoren (10, 10') jeweils ein Verstärkerelement (20; 20') geschaltet ist.

4. Vorrichtung gemäß einem der vorhergehenden Ansprüche, **dadurch gekennzeichnet, daß** das jeweils abgegebene Signal ein einzelner Impuls ist.

5. Vorrichtung gemäß einem der vorhergehenden Ansprüche, **dadurch gekennzeichnet, daß** der Ladungsfluß ein Maß für erfaßte Ionenteilchen ist.

6. Vorrichtung gemäß einem der Ansprüche 2 bis 6, **dadurch gekennzeichnet, daß** jeder der Schaltungszweige (Z; Z') eine Schaltung (50, 60; 50', 60') zum zyklischen Auswählen eines Schwellenwertsignales aus einer Reihe von Schwellenwertsignalen und dem bestimmten Schwellenwertsignal aufweist,
wobei bei Übereinstimmen des integrierten Ladungsflusses mit dem ausgewählten Schwellenwertsignal im beaufschlagten Schaltungszweig (Z; Z') der Komparator (30; 30') ein Signal abgibt und das zyklisch nächste Schwellenwertsignal aus der Reihe ausgewählt wird.

7. Vorrichtung gemäß Anspruch 6, **dadurch gekennzeichnet, daß** die Schwellenwertsignale betragsmäßig in ansteigender Reihenfolge geordnet sind und benachbarte Schwellenwertsignale eine konstante Betragsgrößendifferenz zueinander aufweisen.

8. Verfahren zum Umwandeln von Ladungsfluß in ein Frequenzsignal, die folgende Schrittfolge iterativ durchlaufend:
- Beaufschlagen eines von zwei Schaltungszweigen mit Ladungsfluß,
- Integrieren des Ladungsflusses in dem beaufschlagten Schaltungszweig,
- Vergleichen des integrierten Ladungsflusses mit einem bestimmten Schwellenwertsignal,
- wenn der integrierte Ladungsfluß mit dem bestimmten Schwellenwertsignal übereinstimmt:
- Erzeugen eines Ausgangssignals,
- Zurücksetzen des Integrators des beaufschlagten Schaltungszweiges und
- Beaufschlagen des anderen Schaltungszweiges mit Ladungsfluß.

9. Verfahren gemäß Anspruch 8, **dadurch gekennzeichnet, daß** der integrierte Ladungsfluß spannungsverstärkt wird.

10. Verfahren gemäß Anspruch 8 oder 9, **dadurch gekennzeichnet, daß** das jeweils abgegebene Signal ein einzelner Impuls ist.

11. Verfahren gemäß einem der Ansprüche 8 bis 10, **dadurch gekennzeichnet, daß** der Ladungsfluß ein Maß für erfaßte Ionenteilchen ist.

12. Verfahren gemäß einem der Ansprüche 8 bis 11, **dadurch gekennzeichnet, daß** in dem beaufschlagten Zweig zyklisch ein Schwellenwertsignal aus einer Reihe verschiedener Schwellenwertsignale und dem bestimmten Schwellenwertsignal ausgewählt wird, und bei Übereinstimmen des integrierten Ladungsflusses mit dem ausgewählten Schwellenwertsignal im beaufschlagten Schaltungszweig ein Signal abgegeben wird und das zyklisch nächste Schwellenwertsignal aus der Reihe ausgewählt wird.

13. Verfahren gemäß Anspruch 12, **dadurch gekennzeichnet, daß** die Schwellenwertsignale betragsmäßig in ansteigender Reihenfolge geordnet sind und benachbarte Schwellenwertsignale eine konstante Betragsgrößendifferenz zueinander aufweisen.

14. Vorrichtung zum Umwandeln von Ladungsfluß in ein Frequenzsignal, aufweisend:
zwei parallele Schaltungszweige (Z; Z'), die mit Ladungsfluß beaufschlagbar sind und deren jeder eine Hintereinanderschaltung eines Schaltelements (40; 40'), eines Integrators (10; 10') und eines Komparators (30; 30') sowie eine Schaltung (50, 60; 50', 60') zum zyklischen Auswählen eines Schwellenwertsignales aus einer Reihe vorbestimmter Schwellenwertsignale aufweist,
wobei
jedes der Schaltelemente (40; 40') zum Beaufschlagen des zugehörigen Schaltungszweiges (Z; Z') mit Ladungsfluß dient,
jeder der Integratoren (10; 10') jeweils zum Integrieren des Ladungsflusses dient und rücksetzbar ausgelegt ist und die Komparatoren (30; 30') zum Abgeben eines Signals bei Übereinstimmen des integrierten Ladungsflusses mit einem Schwellenwertsignal ausgelegt sind,
wobei im beaufschlagten Schaltungszweig (Z; Z') bei Übereinstimmen des integrierten Ladungsflusses mit einem Schwellenwertsignal der entsprechende Komparator (30; 30') ein Signal abgibt und in der Schaltung (50, 60; 50', 60') das zyklisch nächste Schwellenwertsignal ausgewählt wird und
wobei, wenn in einem Schaltungszweig (10; 10') ein erstes vorbestimmtes Schwellensignal aus der Reihe von Schwellenwertsignalen erreicht ist, das Schaltelement im anderen Zweig (10';10) durchgeschaltet wird und wobei, wenn in dem einen Schaltungszweig (10; 10')ein zweites vorbestimmtes Schwellensignal aus der Reihe von Schwellenwertsignalen erreicht ist, das zugehörige Schaltelement gesperrt wird und der zugehörige Integrator zurückgesetzt wird.

15. Vorrichtung gemäß Anspruch 14, **dadurch gekennzeichnet, daß** zwischen den Schaltelementen (40; 40') und den Integratoren (10; 10') jeweils ein Verstärkerelement (20; 20') geschaltet ist.

16. Vorrichtung gemäß Anspruch 14 oder 15, **dadurch gekennzeichnet, daß** das jeweils abgegebene Signal ein einzelner Impuls ist.

17. Vorrichtung gemäß einem der Ansprüche 14 bis 16, **dadurch gekennzeichnet, daß** der Ladungsfluß ein Maß für erfaßte Ionenteilchen ist.

18. Vorrichtung gemäß einem der Ansprüche 14 bis 17, **dadurch gekennzeichnet, daß** die Schwellenwertsignale der Reihe betragsmäßig in ansteigender Reihenfolge geordnet sind und benachbarte Schwellenwertsignale eine konstante Betragsgrößendifferenz zueinander aufweisen.

19. Vorrichtung gemäß Anspruch 18, **dadurch gekennzeichnet, daß** das erste vorbestimmte Schwellenwertsignal das betragsmäßig zweitgrößte und das zweite das betragsmäßig größte der Reihe ist.

20. Vorrichtung gemäß einem der Ansprüche 14 bis 19, **dadurch gekennzeichnet, daß** sie Steuermittel (3, 15, 16; 3', 15', 16') aufweist zum Zurücksetzen der integratoren (10; 10') und zum Ansteuern der Schaltelemente (40; 40') bei Übereinstimmen des integrierten Ladungsflusses mit dem zweiten bestimmten Schwellenwertsignal.

21. Verfahren zum Umwandeln von Ladungsfluß in ein Frequenzsignal, die folgende Schrittfolge iterativ durchlaufend:
- Beaufschlagen eines von zwei parallelen Schaltungszweigen mit Ladungsfluß,
- Integrieren des Ladungsflusses in dem mit Ladungsfluß beaufschlagten Schaltungszweig,
- Vergleichen des integrierten Ladungsflusses mit einem Schwellenwertsignal aus einer Reihe von Schwellenwertsignalen,
- wenn der integrierte Ladungsfluß in dem beaufschlagten Schaltungszweig mit dem Schwellenwertsignal übereinstimmt:
- Erzeugen eines Ausgangssignals,
- Auswählen des zyklisch nächsten Schwellenwertsignales aus der Reihe,
- wenn der integrierte Ladungsfluß in dem einen beaufschlagten Schaltungszweig mit einem ersten bestimmten Schwellenwertsignal übereinstimmt:
- Beaufschlagen auch des anderen Schaltungszweiges mit Ladungsfluß,
- wenn der integrierte Ladungsfluß in dem einen beaufschlagten Schaltungszweig mit einem zweiten bestimmten Schwellenwertsignal übereinstimmt:
- Trennen dieses Schaltungszweiges vom Ladungsfluß.

22. Verfahren gemäß Anspruch 21, **dadurch gekennzeichnet, daß** der integrierte Ladungsfluß spannungsverstärkt wird.

23. Verfahren gemäß Anspruch 21 oder 22, **dadurch gekennzeichnet, daß** das jeweils abgegebene Signal ein einzelner Impuls ist.

24. Verfahren gemäß einem der Ansprüche 21 bis 23, **dadurch gekennzeichnet, daß** der Ladungsfluß ein Maß für erfaßte Ionenteilchen ist.

25. Verfahren gemäß einem der Ansprüche 21 bis 24, **dadurch gekennzeichnet, daß** die Schwellenwertsignale betragsmäßig in ansteigender Reihenfolge geordnet sind und benachbarte Schwellenwertsignale eine konstante Betragsgrößendifferenz zueinander aufweisen.

26. Verfahren gemäß Anspruch 25, **dadurch gekennzeichnet, daß** das erste vorbestimmte Schwellenwertsignal das betragsmäßig zweitgrößte und das zweite das betragsmäßig größte der Reihe ist.

## Claims

1. Device for converting flow of charge into a frequency signal, having:
two parallel circuit branches (Z; Z'),
which are arranged to receive flow of charge alternately and each of which has a series arrangement of a switching element (40; 40'), an integrator (10; 10') and a comparator (30; 30'), wherein the switching elements (40; 40') serve to supply the flow of charge to one of the two circuit branches (Z; Z') and in the receiving circuit branch (Z; Z') the integrator (10; 10') serves to integrate the flow of charge and is configured to be resettable and the comparator (30; 30') is configured to emit a signal when the integrated flow of charge corresponds to a specific threshold value signal.

2. Device according to claim 1, **characterised in that** it has control means (3, 15, 16; 3', 15', 16') for resetting the integrators (10; 10') and for actuating the switching elements (40; 40') when the integrated flow of charge corresponds to the specific threshold value signal.

3. Device according to claim 1 or 2, **characterised in that** an amplifier (20, 20') is connected between each switching element (40, 40') and the respective integrator (10, 10').

4. Device according to any one of the preceding claims, **characterised in that** the signal emitted in each case is a single pulse.

5. Device according to any one of the preceding claims, **characterised in that** the flow of charge is a measure of detected ion particles.

6. Device according to any one of claims 2 to 6, **characterised in that** each of the circuit branches (Z; Z') has a circuit (50, 60; 50', 60') for the cyclic selection of a threshold value signal from a series of threshold value signals and the specific threshold value signal, and when the integrated flow of charge corresponds to the selected threshold value signal in the receiving circuit branch (Z; Z') the comparator (30; 30') emits a signal and the threshold value signal that is next in the cycle is selected from the series.

7. Device according to claim 6, **characterised in that** the threshold value signals are ordered in ascending order in terms of their value and adjacent threshold value signals have a constant difference in value relative to one another.

8. Method for converting flow of charge into a frequency signal, iteratively executing the following sequence of steps:
- supplying flow of charge to one of two circuit branches,
- integrating the flow of charge in the receiving circuit branch,
- comparing the integrated flow of charge with a specific threshold value signal,
- when the integrated flow of charge corresponds to the specific threshold value signal:
- generating an output signal
- resetting the integrator of the receiving circuit branch and
- supplying flow of charge to the other circuit branch.

9. Method according to claim 8, **characterised in that** the integrated flow of charge is voltage-amplified.

10. Method according to claim 8 or 9, **characterised in that** the signal emitted in each case is a single pulse.

11. Method according to any one of claims 8 to 10, **characterised in that** the flow of charge is a measure of detected ion particles.

12. Method according to any one of claims 8 to 11, **characterised in that** in the receiving branch a threshold value signal is selected cyclically from a series of different threshold value signals and the specific threshold value signal, and when the integrated flow of charge corresponds to the selected threshold value signal in the receiving circuit branch a signal is emitted and the threshold value signal that is next in the cycle is selected from the series.

13. Method according to claim 12, **characterised in that** the threshold value signals are ordered in ascending order in terms of their value and adjacent threshold value signals have a constant difference in value relative to one another.

14. Device for converting flow of charge into a frequency signal, having:
two parallel circuit branches (Z; Z'), which are arranged to receive flow of charge and each of which has a series arrangement of a switching element (40; 40'), an integrator (10; 10') and a comparator (30; 30') and a circuit (50, 60; 50', 60') for cyclically selecting a threshold value signal from a series of predetermined threshold value signals,
wherein
each of the switching elements (40; 40') serves to supply flow of charge to the associated circuit branch (Z; Z'),
each of the integrators (10; 10') serves to integrate the flow of charge and is configured to be resettable and the comparators (30; 30') are configured to emit a signal when the integrated flow of charge corresponds to a threshold value signal,
wherein in the receiving circuit branch (Z; Z'), when the integrated flow of charge corresponds to a threshold value signal the corresponding comparator (30; 30') emits a signal and in the circuit (50, 60; 50', 60') the threshold value signal that is next in the cycle is selected and
wherein when in one circuit branch (10; 10') a first predetermined threshold signal from the series of threshold value signals has been reached, the switching element in the other branch (10'; 10) is connected and wherein when in the one circuit branch (10; 10') a second predetermined threshold signal from the series of threshold value signals has been reached, the associated switching element is disabled and the associated integrator is reset.

15. Device according to claim 14, **characterised in that** an amplifier element (20; 20') is connected between each switching element (40; 40') and the respective integrator (10; 10').

16. Device according to claim 14 or 15, **characterised in that** the signal emitted in each case is a single pulse.

17. Device according to any one of claims 14 to 16, **characterised in that** the flow of charge is a measure of detected ion particles.

18. Device according to any one of claims 14 to 17, **characterised in that** the threshold value signals of the series are ordered in ascending order in terms of their value and adjacent threshold value signals have a constant difference in value relative to one another.

19. Device according to claim 18, **characterised in that** the first predetermined threshold value signal is the second greatest in terms of value and the second is the greatest in terms of value of the series.

20. Device according to any one of claims 14 to 19, **characterised in that** it has control means (3, 15, 16; 3', 15', 16') for resetting the integrators (10; 10') and for actuating the switching elements (40; 40') when the integrated flow of charge corresponds to the second specific threshold value signal.

21. Method for converting flow of charge into a frequency signal, iteratively executing the following sequence of steps:
- supplying flow of charge to one of two parallel circuit branches,
- integrating the flow of charge in the circuit branch receiving flow of charge,
- comparing the integrated flow of charge with a threshold value signal from a series of threshold value signals,
- when the integrated flow of charge in the receiving circuit branch corresponds to the threshold value signal:
- generating an output signal
- selecting the threshold value signal that is next in the cycle from the series,
- when the integrated flow of charge in the one receiving circuit branch corresponds to a first specific threshold value signal:
- supplying flow of charge also to the other circuit branch,
- when the integrated flow of charge in the one receiving circuit branch corresponds to a second specific threshold value signal:
- disconnecting that circuit branch from the flow of charge.

22. Method according to claim 21, **characterised in that** the integrated flow of charge is voltage-amplified.

23. Method according to claim 21 or 22, **characterised in that** the signal emitted in each case is a single pulse.

24. Method according to any one of claims 21 to 23, **characterised in that** the flow of charge is a measure of detected ion particles.

25. Method according to any one of claims 21 to 24, **characterised in that** the threshold value signals are ordered in ascending order in terms of their value and adjacent threshold value signals have a constant difference in value relative to one another.

26. Method according to claim 25, **characterised in that** the first predetermined threshold value signal is the second greatest in terms of value and the second is the greatest in terms of value of the series.

## Revendications

1. Dispositif pour convertir un flux de charge en un signal de fréquence, comprenant :
deux branches de circuit (Z ; Z') parallèles,
auxquelles le flux de charge est appliqué alternativement et qui présentent chacune un montage en série d'un élément de commutation (40 ; 40') d'un intégrateur (10 ; 10') et d'un comparateur (30, 30'),
les éléments de commutation (40 ; 40') servant à appliquer le flux de charge à l'une des deux branches de circuit (Z ; Z'),
l'intégrateur (10 ; 10'), dans la branche de circuit (Z ; Z') à laquelle le flux de charge est appliqué, servant à intégrer le flux de charge et pouvant être réinitialisé et
le comparateur (30 ; 30') étant agencé pour délivrer un signal lorsque le flux de charge intégré correspond à un signal de valeur limite déterminé.

2. Dispositif selon la revendication 1, **caractérisé par le fait qu'**il comprend des moyens de commande (3, 15, 16 ; 3', 15', 16') pour réinitialiser les intégrateurs (10 ; 10') et pour commander les éléments de commutation (40 ; 40'), lorsque le flux de charge intégré correspond au signal de valeur limite déterminé.

3. Dispositif selon la revendication 1 ou 2, **caractérisé par le fait qu'**entre les éléments de commutation (40 ; 40') et les intégrateurs (10 ; 10') est branché chaque fois un élément amplificateur (20 ; 20').

4. Dispositif selon une des revendications précédentes, **caractérisé par le fait que** le signal délivré chaque fois est une impulsion isolée.

5. Dispositif selon une des revendications précédentes, **caractérisé par le fait que** le flux de charge est une mesure pour les particules ions mesurées.

6. Dispositif selon une des revendications 2 à 6, **caractérisé par le fait que** chacune des branches de circuit (Z ; Z') comporte un circuit (50, 60 ; 50', 60') pour la sélection cyclique d'un signal de valeur limite à partir d'une série de signaux de valeur limite et du signal de valeur limite déterminé, le comparateur (30 ; 30') délivrant un signal lorsque le flux de charge intégré correspond au signal de valeur limite sélectionné dans la branche de circuit (Z ; Z') à laquelle le flux de charge est appliqué et le signal de valeur limite de la série le plus proche dans le cycle étant sélectionné.

7. Dispositif selon la revendication 6, **caractérisé par le fait que** les signaux de valeur limite sont rangés par ordre croissant de valeur et que des signaux de valeur limite voisins présentent une différence en valeur constante les uns par rapport aux autres.

8. Procédé pour convertir un flux de charge en un signal de fréquence, comprenant les étapes suivantes qui sont parcourues de manière itérative :
• application d'un flux de charge à une branche de circuit parmi deux branches de circuit (Z ; Z'),
• intégration du flux de charge dans la branche de circuit à laquelle le flux de charge est appliqué,
• comparaison du flux de charge intégré avec un signal de valeur limite déterminé,
• lorsque le flux de charge intégré correspond au signal de valeur limite déterminé :
• génération d'un signal de sortie,
• réinitialisation de l'intégrateur de la branche de circuit à laquelle le flux de charge est appliqué, et
• application d'un flux de charge à l'autre branche de circuit.

9. Procédé selon la revendication 8, **caractérisé par le fait que** le flux de charge intégré est amplifié en tension.

10. Procédé selon la revendication 8 ou 9, **caractérisé par le fait que** le signal délivré est chaque fois une impulsion isolée.

11. Procédé selon une des revendications 8 à 10, **caractérisé par le fait que** le flux de charge est une mesure pour les particules ions mesurées.

12. Procédé selon une des revendications 8 à 11, **caractérisé par le fait que** dans la branche de circuit à laquelle le flux de charge est appliqué, un signal de valeur limite est sélectionné de manière cyclique à partir d'une série de signaux de valeur limite différents et du signal de valeur limite déterminé, et lorsque le flux de charge intégré correspond au signal de valeur limite sélectionné dans la branche de circuit à laquelle le flux de charge est appliqué, un signal est délivré et la valeur de signal limite de la série la plus proche dans le cycle est sélectionnée.

13. Procédé selon la revendication 12, **caractérisé par le fait que** les signaux de valeur limite sont classés par ordre croissant de valeur et que des signaux de valeur limite voisins présentent une différence en valeur constante les uns par rapport aux autres.

14. Dispositif pour convertir un flux de charge en un signal de fréquence, comprenant :
deux branches de circuit (Z ; Z') parallèles, auxquelles le flux de charge est appliqué et qui comportent chacune un montage en série d'un élément de commutation (40 ; 40'), d'un intégrateur (10 ; 10') et d'un comparateur (30, 30'), ainsi qu'un circuit (50, 60 ; 50', 60') pour sélectionner de manière cyclique un signal de valeur limite à partir d'une série de signaux de valeur limite déterminés,
chacun des éléments de commutation (40 ; 40') servant à appliquer le flux de charge à la branche de circuit (Z ; Z') concernée et
chacun des intégrateurs (10 ; 10') servant à intégrer le flux de charge et pouvant être réinitialisé et les comparateurs (30 ; 30') étant agencés pour délivrer un signal lorsque le flux de charge intégré correspond à un signal de valeur limite déterminé,
dans lequel, dans la branche de circuit (Z ; Z') à laquelle le flux de charge est appliqué, lorsque le flux de charge intégré correspond à un signal de valeur limite déterminé, le comparateur (30 ; 30') délivre un signal et le signal de valeur limite suivant dans le cycle est sélectionné dans le circuit (50, 60 ; 50', 60') et
dans lequel, lorsque dans une branche de circuit (10 ; 10') un premier signal de valeur limite prédéterminé dans la série de signaux de valeur limite est atteint, l'élément de commutation dans l'autre branche de circuit (10 ; 10') est commuté à l'état passant et
dans lequel, lorsque dans ladite branche de circuit (10 ; 10') un deuxième signal de valeur limite prédéterminé dans la série de signaux de valeur limite est atteint, l'élément de commutation concerné est commuté à l'état bloquant et l'intégrateur associé est réinitialisé.

15. Dispositif selon la revendication 14, **caractérisé par le fait qu'**entre les éléments de commutation (40 ; 40') et les intégrateurs (10 ; 10') est branché chaque fois un élément amplificateur (20 ; 20').

16. Dispositif selon la revendication 14 ou 15, **caractérisé par le fait que** le signal délivré chaque fois est une impulsion isolée.

17. Dispositif selon une des revendications 14 à 16, **caractérisé par le fait que** le flux de charge est une mesure pour les particules ions mesurées.

18. Dispositif selon une des revendications 14 à 17, **caractérisé par le fait que** les signaux de valeur limite de la série sont rangés par ordre croissant de valeur et que des signaux de valeur limite voisins présentent une différence en valeur constante les uns par rapport aux autres.

19. Dispositif selon la revendication 18, **caractérisé par le fait que** le premier signal de valeur limite prédéterminé, en valeur, est le deuxième plus grand signal de la série et le deuxième signal de valeur limite prédéterminé, en valeur, est le plus grand signal.

20. Dispositif selon une des revendications 14 à 19, **caractérisé par le fait qu'**il comporte des moyens de commande (3, 15, 16 ; 3', 15', 16') pour réinitialiser les intégrateurs (10 ; 10') et pour commander les éléments de commutation (40 ; 40') lorsque le flux de charge intégré correspond au deuxième signal de valeur limite déterminé.

21. Procédé pour convertir un flux de charge en un signal de fréquence, comprenant les étapes suivantes qui sont parcourues de manière itérative :
• application d'un flux de charge à une branche de circuit parmi deux branches de circuit (Z ; Z') parallèles,
• intégration du flux de charge dans la branche de circuit à laquelle le flux de charge est appliqué,
• comparaison du flux de charge intégré avec un signal de valeur limite pris dans une série de signaux de valeur limite
• lorsque le flux de charge intégré, dans la branche de circuit à laquelle il est appliqué, correspond au signal de valeur limite :
• génération d'un signal de sortie,
• sélection du signal de valeur limite de la série suivant dans le cycle,
• lorsque le flux de charge intégré dans ladite branche de circuit correspond à un premier signal de valeur limite déterminé :
• application d'un flux de charge à l'autre branche de circuit
• lorsque le flux de charge intégré, dans ladite branche de circuit, correspond à un deuxième signal de valeur limite déterminé :
• séparation de cette branche de circuit du flux de charge.

22. Procédé selon la revendication 21, **caractérisé par le fait que** le flux de charge intégré est amplifié en tension.

23. Procédé selon la revendication 21 ou 22, **caractérisé par le fait que** le signal délivré est chaque fois une impulsion isolée.

24. Procédé selon une des revendications 21 à 23, **caractérisé par le fait que** le flux de charge est une mesure pour les particules ions mesurées.

25. Procédé selon une des revendications 21 à 24, **caractérisé par le fait que** les signaux de valeur limite sont classés par ordre croissant de valeur et que des signaux de valeur limite voisins présentent une différence en valeur constante les uns par rapport aux autres.

26. Procédé selon la revendication 25, **caractérisé par le fait que** le premier signal de valeur limite déterminé, en valeur, est le deuxième plus grand signal de la série et le deuxième signal de valeur limite prédéterminé, en valeur, est le plus grand signal de la série.
